Europäisches Patentamt

European Patent Office

Office européen des brevets

(19)

(11) **EP 1 672 644 A1**

(12) **EUROPEAN PATENT APPLICATION**

(43) Date of publication:
**21.06.2006 Bulletin 2006/25**

(51) Int Cl.:
***G11C 11/412*** (2006.01)

(21) Application number: **05270091.1**

(22) Date of filing: **14.12.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **16.12.2004 US 14315**

(71) Applicant: **BAE SYSTEMS Information and Electronic Systems Integration, Inc. Nashua, NH 03061 (US)**

(72) Inventors:
• **Doyle, Scott**
  **Centreville, VA 20121 (US)**
• **Thoma, Nandor G.**
  **Palm Bay, FL 32907 (US)**

(74) Representative: **Mackett, Margaret Dawn et al BAE Systems plc Intellectual Property Department Lancaster House - P.O. Box 87 Farnborough Aerospace Centre GB-Farnborough, Hampshire GU14 6YU (GB)**

(54) **Single-event upset tolerant static random access memory cell**

(57)    A single-event upset tolerant random access memory cell (20) is disclosed that includes first and second sets of access transistors (31, 32, 33, 34) along with a first and second sets of dual-path inverters. The first set of access transistors (31, 32) is coupled to a first bitline BL, and the second set of access transistors (33, 34) is coupled to a second bitline BL that is complementary to the first bitline (BL). The first set of dual-path inverters (21, 22, 23, 24) is coupled to the first set of access transistors (31, 32); and the second set of dual-path inverters (25, 26, 27, 28) is coupled to the second set of access transistors (33, 34).

Figure 2

EP 1 672 644 A1

**Description**

The present invention relates to integrated circuits in general, and in particular to static random access memories. Still more particularly, the present invention relates to single-event upset tolerant static random access memory cells.

In certain environments, such as satellite orbital space, in which the level of radiation is relatively intense, electronic devices that utilize static random access memories (SRAMS) are more susceptible to single-event upsets (SEUs) or soft errors than they would have otherwise in terrestrial environments. These SEUs are typically caused by electron-hole pairs created by, and travelling along the path of, a single energetic particle as the single energetic particle passes through the memory cells of an SRAM device. If the energetic particle generates a critical charge within a storage node of an SRAM cell, the logic state of the SRAM cell will be upset.

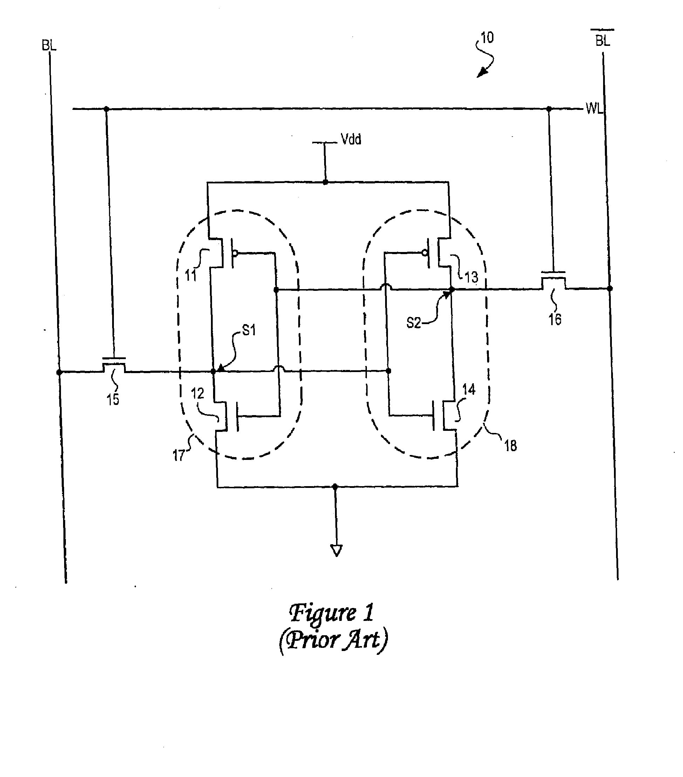

Referring now to the drawings and in particular to Figure 1, there is illustrated a schematic diagram of a conventional SRAM cell. As shown, an SRAM cell 10 is constructed with two cross-coupled complementary metal oxide semiconductor (CMOS) inverters 17 and 18. Inverter 17 includes a p-channel transistor 11 and an n-channel transistor 12, and inverter 18 includes a p-channel transistor 13 and an n-channel transistor 14. The gates of transistors 11 and 12 are connected to the drains of transistors 13 and 14, and the gates of transistors 13 and 14 are connected to the drains of transistors 11 and 12. Such an arrangement of inverters 17, 18 is commonly referred to as a cross-coupled inverter, and the two lines connecting the gates and the drains of inverters 17 and 18 are commonly referred to as cross-coupling lines.

An n-channel access transistor 15, having its gate connected to a wordline WL, is coupled between a bitline BL and a node S1 within inverter 17. Similarly, an n-channel access transistor 16, having its gate connected to wordline WL, is coupled between a bitline $\overline{BL}$ and a node S2 within inverter 18. When enabled, access transistors 15, 16 allow data to pass in and out of SRAM cell 10 from bitlines BL and $\overline{BL}$ respectively. Access transistors 15 and 16 are enabled by wordline WL, which has a state that is a function of the row address within an SRAM device. The row address is decoded by a row decoder (not shown) within the SRAM device such that only one out of n wordlines is enabled, where n is the total number of rows of memory cells in the SRAM device.

During operation, the voltages of nodes S1 and S2 are logical complements of one another due to the cross-coupling of inverters 17 and 18. When wordline WL is energized by the row decoder according to the row address received, access transistors 15 and 16 will be turned on, coupling nodes S1 and S2 to bit lines BL and $\overline{BL}$, respectively. Accordingly when wordline WL is high, the state of SRAM cell 10 can establish a differential voltage on BL and $\overline{BL}$.

The logic state of SRAM cell 10 can be changed by an SEU in many ways. For example, if a single energetic particle, such as an alpha particle, strikes the drain of transistor 11 of inverter 17, electrons will diffuse towards a power supply $V_{dd}$ of inverter 17, and holes collected at the drain of transistor 11 will change the output voltage of inverter 17 at node S1 from a logic low to a logic high when transistor 12 is on and transistor 11 is off. However, if the alpha particle strikes the drain of transistor 12 of inverter 17, holes will drift towards ground, and electrons collected at the drain will change the output voltage of inverter 17 at node S1 from a logic high to a logic low when transistor 11 is on and transistor 12 is off. Because SRAM cell 10 is susceptible to SEU, it would be desirable to provide an SEU tolerant SRAM cell.

In accordance with one aspect of the present invention, a single-event upset tolerant memory cell includes a first and second sets of access transistors along with a first and second sets of dual-path inverters. The first set of access transistors is coupled to a first bitline, and the second set of access transistors is coupled to a second bitline that is complementary to the first bitline. The first set of dual-path inverters is coupled to the first set of access transistors, and second set of dual-path inverters is coupled to the second set of access transistors. The first set of dual-path inverters includes a first transistor connected to a second transistor in series and a third transistor connected to a fourth transistor in series. The second set of dual-path inverters includes a fifth transistor connected to a sixth transistor in series and a seventh transistor connected to an eighth transistor in series.

All features and advantages of the present invention will become apparent in the following detailed written description.

The invention itself, as well as a preferred mode of use, further objects, and advantages thereof, will best be understood by reference, by way of example only, to the following detailed description of an illustrative embodiment when read in conjunction with the accompanying drawings, wherein:

Figure 1 is a schematic diagram of a static random access memory (SRAM) cell according to the prior art;

Figure 2 is a schematic diagram of a single-event upset (SEU) tolerant SRAM cell in accordance with an embodiment of the present invention; and

Figure 3 is a block diagram of an electronic system having a memory device in which the single-event upset (SEU) tolerant SRAM cell of the present invention is incorporated.

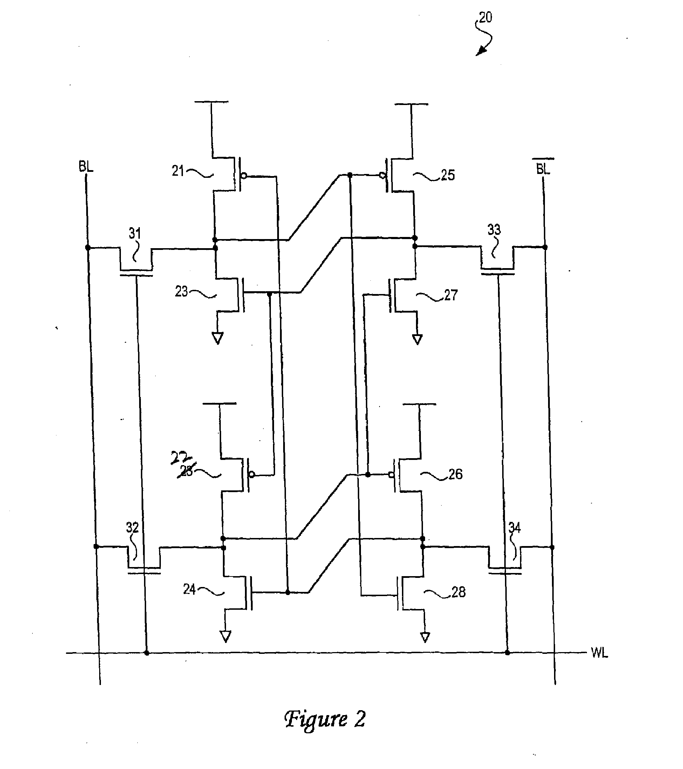

With reference now to Figure 2, there is illustrated a schematic diagram of a single-event upset (SEU) tolerant static random access memory (SRAM) cell, in accordance with a preferred embodiment of the present invention. As shown, an SRAM cell 20 includes four p-channel access transistors 31, 32, 33, 34 and two sets of dual-path inverters. The first set of dual-path inverters includes p-channel transistors 21, 22 and n-channel transistors 23, 24. The second set of dual-path inverters includes p-channel transistors 25, 26 and n-channel transistors 27, 28. Transistor 21 is connected in series with transistor 23, and transistor 22 is connected in series with transistor 24. The gate of transistor 21 is connected to the gate of transistor 24 as well as the node between transistors 26 and 28. The gate of transistor 22 is connected to the gate of transistor 23 as well as the node between transistors 25 and 27. Transistor 25 is connected in series with transistor 27, and transistor 26 is connected in series with transistor 28. The gate of transistor 25 is connected to the gate of transistor 28 as well as the node between transistors 21 and 23. The gate of transistor 26 is connected to the gate of transistor 27 as well as the node between transistors 22 and 24.

In addition, access transistor 33 is connected between the first output of the first set of dual-path inverter and a bitline $\overline{BL}$, and access transistor 34 is connected between the second output of the first set of dual-path inverter and bitline $\overline{BL}$. Specifically, the drain of access transistor 33 is connected to the node between transistors 25 and 27; the drain of access transistor 34 is connected to the node between transistors 26 and 28.

Similarly, access transistor 32 is connected between the first output of the second set of dual-path inverter and a bitline BL, and access transistor 31 is connected between the second output of the second set of dual-path inverter and bitline BL. Specifically, the drain of access transistor 32 is connected to the node between transistors 22 and 24; the drain of access transistor 31 is connected to the node between transistors 21 and 23. The gates of access transistors 31, 32, 33, 34 are all connected to a wordline WL. Access transistors 31, 32, 33, 34 can be p-channel transistors or n-channel transistors.

During operation, when bitline BL is being precharged to a logical high potential, the potential is also impressed on the associated nodes of the two cross-coupled dual-path inverters. When SRAM cell 20 is being accessed, either BL or BL begins to decrease in voltage amplitude as charges are being removed by the corresponding bitline of SRAM cell 20.

SRAM cell 20 includes four internal storage nodes, and they are the node between transistors 21 and 23, the node between transistors 22 and 24, the node between transistors 25 and 27, and the node between transistors 26 and 28. Any one of the above-mentioned four internal nodes of SRAM cell 20 can be tied either to ground or $V_{dd}$ (not shown) without changing the state of SRAM cell 20 permanently. Hence, SRAM cell 20 can sustain its intended state even after a hit by a charged particle.

SRAM cell 20 may also be able to sustain its intended state even after two different hits by two separate charged particles. However, the probability that two charged particles intersect SRAM cell 20 at the same time with one to each of four internal storage nodes to cause an SEU to occur is about four orders of magnitude less than the probability of a single hit. Thus, SRAM cell 20 is relatively immune against SEUs.

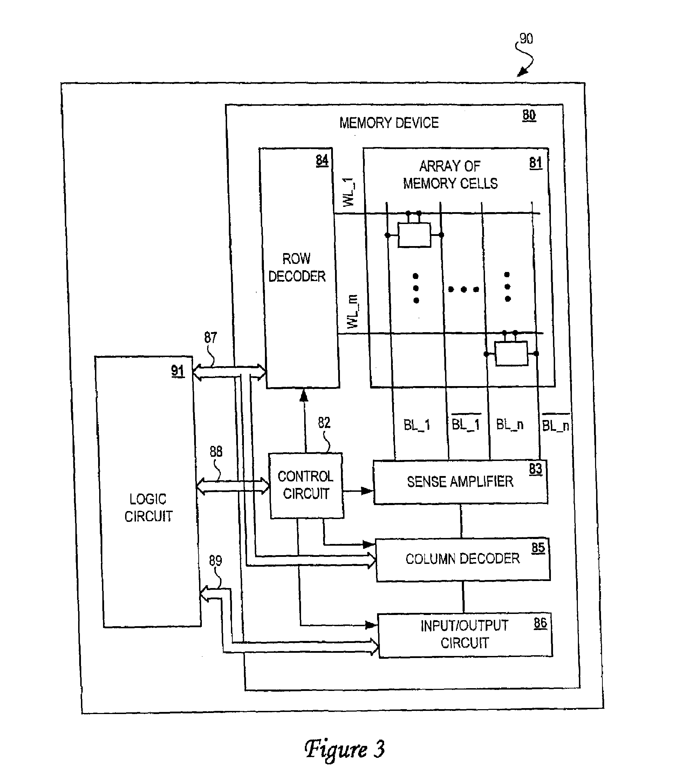

As has been described, the present invention provides an SEU tolerant SRAM cell. The SEU tolerant SRAM cell of the present invention may be utilized within a variety of electronic systems that employ SRAM devices. For example, referring now to Figure 3, there is depicted a block diagram of an electronic system in which a preferred embodiment of the present invention may be incorporated. As shown, an electronic system 90 includes a group of logic circuits 91 coupled to a memory device 80. Electronic system 90 may be, for example, a processor, a memory controller, a chip set or any system that stores data in a memory device such as memory device 80.

Electronic system 90 is coupled to a row decoder 84 and a column decoder 85 of memory device 80 via address lines 87. Electronic system 90 is also coupled to a control circuit 82 of memory device 80 via control lines 88. In addition, electronic system 90 is coupled to an input/output circuit 86 of memory device 80 via input/output lines 89.

Memory device 80 includes a sense amplifier 83 and a memory cell array 81. Memory cell array 81 includes a number of wordlines (i.e. WL_1 through WL_m) and a number of bitline pairs (i.e. BL_1 through BL_n and $\overline{BL}\_1$ through $\overline{BL}\_n$). Along with sense amplifier 83, memory cell array 81 is constructed to use a memory cell sensing scheme such that a bitline pair is to be used in reading and writing data into a SRAM cell such as memory cell array 81.

While the invention has been particularly shown and described with reference to a preferred embodiment, it will be understood by those skilled in the art that various changes in form and detail may be made therein without departing from the present invention.

**Claims**

1. A single-event upset tolerant memory cell, comprising:

    a first set of access transistors coupled to a first bitline;

a second set of access transistors coupled to a second bitline, wherein said second bitline is complementary to said first bitline;

a first set of dual-path inverters coupled to said first set of access transistors, wherein said first set of dual-path inverters includes a first transistor connected to a second transistor in series and a third transistor connected to a fourth transistor in series; and

a second set of dual-path inverters coupled to said second set of access transistors, wherein said second set of dual-path inverters includes a fifth transistor connected to a sixth transistor in series and a seventh transistor connected to an eighth transistor in series.

2. A memory cell according to Claim 1, wherein said first and second sets of access transistors are p-channel transistors.

3. A memory cell according to Claim 1, wherein said first and second sets of access transistors are n-channel transistors.

4. A memory cell according to Claim 1, wherein a first transistor of said first set of access transistors is connected to a node between said first and second transistors; a second transistor of said first set of access transistors is connected to a node between said third and fourth transistors; a first transistor of said second set of access transistors is connected to a node between said fifth and sixth transistors; and a second transistor of said second set of access transistors is connected to a node between said seventh and eight transistors.

5. A memory cell according to Claim 4, wherein said first, third, fifth and seventh transistors are p-channel transistors, and said second, fourth, sixth and eight transistors are n-channel transistors.

6. A memory cell according to Claim 4 or 5, wherein gates of said first and fourth transistors are connected to a node between said seventh and eighth transistors; gates of said second and third transistors are connected to a node between said fifth and sixth transistors; gates of said fifth and eight transistors are connected to a node between said first and second transistors; and gates of said sixth and seventh transistors are connected to a node between said third and fourth transistors.

7. A memory cell according to any one of Claims 1 to 6, wherein a first output of said first set of dual-path inverter is connected to a second input of said second set of dual-path inverter; a second output of said first set of dual-path inverter is connected to a first input of said second set of dual-path inverter; a first output of said second set of dual-path inverter is connected to a second input of said first set of dual-path inverter; and a second output of said second set of dual-path inverter is connected to a first input of said first set of dual-path inverter.

8. A memory device comprising a sense amplifier; and a plurality of memory cells coupled to said sense amplifier, at least one of said memory cells comprising a single-event upset tolerant memory cell according to any one of Claims 1 to 7.

9. An electronic system comprising a plurality of logic circuits; and a memory device coupled to said logic circuits, said memory comprising a memory cell according to Claim 8.

Figure 1
(Prior Art)

*Figure 2*

*Figure 3*

**European Patent Office**

**EUROPEAN SEARCH REPORT**

Application Number

EP 05 27 0091

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/018372 A1 (THOMA NANDOR G ET AL) 14 February 2002 (2002-02-14) * paragraphs [0025] - [0032]; figure 6 * ----- | 1-9 | G11C11/412 |
| X | US 2003/117221 A1 (KNOWLES KENNETH R ET AL) 26 June 2003 (2003-06-26) * paragraph [0010]; figure 1 * ----- | 1-9 | |

TECHNICAL FIELDS SEARCHED (IPC)

G11C

The present search report has been drawn up for all claims

| Place of search | Date of completion of the search | Examiner |
|---|---|---|
| Munich | 16 March 2006 | Gaertner, W |

EPO FORM 1503 03.82 (P04C01)

**ANNEX TO THE EUROPEAN SEARCH REPORT
ON EUROPEAN PATENT APPLICATION NO.**

EP 05 27 0091

This annex lists the patent family members relating to the patent documents cited in the above-mentioned European search report.
The members are as contained in the European Patent Office EDP file on
The European Patent Office is in no way liable for these particulars which are merely given for the purpose of information.

16-03-2006

| Patent document cited in search report | Publication date | Patent family member(s) | Publication date |
|---|---|---|---|
| US 2002018372 A1 | 14-02-2002 | NONE | |
| US 2003117221 A1 | 26-06-2003 | NONE | |

EPO FORM P0459

For more details about this annex : see Official Journal of the European Patent Office, No. 12/82